# EUROPEAN PATENT APPLICATION

(11) **EP 4 704 534 A1**
(43) Date of publication of application: **04.03.2026**
(21) Application number: 24772911.4
(22) Date of filing: 05.07.2024
(51) Int. Cl.: H10K 59/12, H10K 59/40, H10K 59/82

(54) **DISPLAY PANEL AND DISPLAY DEVICE**

(30) Priority: 11.06.2024 CN 202410750197
(71) Applicant: Wuhan China Star Optoelectronics Semiconductor Display Technology Co., Ltd., Wuhan, Hubei 430079 (CN)
(72) Inventor: JIANG, Pan, Wuhan, Hubei 430079 (CN); FANG, Hong, Wuhan, Hubei 430079 (CN); HU, Jinwen, Wuhan, Hubei 430079 (CN)
(74) Representative: Herrero & Asociados, S.L.
(86) International application number: PCT/CN2024/103840
(87) International publication number: WO 2025/255883

(57) **Abstract**

The present disclosure provides a display panel and a display device. **In** this display panel, at least one of an interlayer insulation portion and an isolation portion includes a groove formed in an interval area, and thus the groove may release film stress of at least one of the interlayer insulation portion and the isolation portion, thereby reducing interface stress between the interlayer insulation portion and the isolation portion, which may avoid disengagement between the interlayer insulation portion and the isolation portion, and may prevent the disengagement from further spreading when the interlayer insulation portion and the isolation portion are disengaged.

## Description

This application claims priority to the Chinese patent application NO. 202410750197.4 filed on June 11, 2024, the entire content of which is incorporated into this disclosure by reference.

### TECHNICAL FIELD

The present disclosure relates to the field of display technology, and in particularly, relates to a display panel and a display device.

### BACKGROUND

A display device generally consists of a display panel and a drive chip. By providing binding terminal on the display panel and binding the drive chip to the binding terminal, a signal connection between the display panel and the drive chip is achieved, thereby realizing normal operation of the display device. An existing display device will undergo reliability testing after its display panel and drive chip are bound. The reliability testing generally involves placing the display device in an environment with a temperature of 85 degrees Celsius and a humidity of 85% and observing and detecting any defect in the display device. During the testing process of the existing display device, it was discovered that in a binding area of the display panel, disengagement between an interlayer insulation layer and an insulation layer in a touch layer would result in abnormal display when the display device was lit.

Therefore, the existing display device has a technical problem that the disengagement between the interlayer insulation layer and the insulation layer in the touch layer results in abnormal display of the display device.

### SUMMARY

Embodiments of the present disclosure provide a display panel and a display device to solve the technical problem in existing display devices that disengagement between the interlayer insulation layer and the insulation layer in the touch layer results in abnormal display of the display device.

In order to solve the above problems, the technical solutions provided by this disclosure are as follows.

Embodiments of the present disclosure provides a display panel. The display panel includes a display area and a binding area located on at least one side of the display area. The binding area includes a plurality of terminal areas and a plurality of interval areas, each interval area is located between two adjacent ones of the plurality of terminal areas, and each terminal area is provided with a binding terminal. The display panel includes:
a substrate;
an interlayer insulation layer disposed on one side of the substrate, wherein the interlayer insulation layer includes an interlayer insulation portion provided in the binding area;
a source and drain layer disposed on a side of the interlayer insulation layer away from the substrate, wherein the source and drain layer includes a source and drain portion provided in the binding area;
a touch layer disposed on a side of the source and drain layer away from the interlayer insulation layer, wherein the touch layer includes an isolation layer, and the isolation layer includes an isolation portion provided in the binding area;
wherein in the binding area, the source and drain portion is disposed between the interlayer insulation portion and the isolation portion, the isolation portion is in contact with the source and drain portion and the interlayer insulation portion, and at least one of the interlayer insulation portion and the isolation portion comprises one or more grooves each formed in a corresponding interval area of the plurality of interval areas.

At the same time, embodiments of the present disclosure provide a display device, which includes the display panel as described in any of the above embodiments and a drive chip, and the drive chip is connected to the binding terminal in the display panel.

### BRIEF DESCRIPTION OF THE DRAWINGS

The technical solutions and other beneficial effects of the present disclosure will be apparent through a detailed description of the specific embodiments of the present disclosure in conjunction with the accompanying drawings.
FIG. 1 is a schematic structural diagram of an existing display device according to some embodiments of the present disclosure.
FIG. 2 is a schematic diagram of a display panel according to some embodiments of the present disclosure.
FIG. 3 is a schematic diagram of a binding area of the display panel according to some embodiments of the present disclosure.
FIG. 4 is another schematic diagram of a display panel according to some embodiments of the present disclosure.
FIG. 5 is a cross-sectional view of the display panel in FIG. 3 along the line A-A.
FIG. 6 is another schematic diagram of a display panel according to some embodiments of the present disclosure.
FIG. 7 is another cross-sectional view of the display panel in FIG. 3 along the line A-A.
FIG. 8 is another cross-sectional view of the display panel in FIG. 3 along the line A-A.
FIG. 9 is another cross-sectional view of the display panel in FIG. 3 along the line A-A.
FIG. 10 is another schematic diagram of a display panel according to some embodiments of the present disclosure.
FIG. 11 is a cross-sectional view of the display panel in FIG. 3 along the line B-B.
FIG. 12 is another cross-sectional view of the display panel in FIG. 3 along the line A-A.
FIG. 13 is another schematic diagram of a binding area of the display panel according to some embodiments of the present disclosure.
FIG. 14 is another schematic diagram of a binding area of the display panel according to some embodiments of the present disclosure.
FIG. 15 is a stress cloud diagram of an interface between a first touch insulation layer and an interlayer insulation layer in the binding area of the display device in FIG. 1.
FIG. 16 is a stress cloud diagram of an interface between a first touch insulation layer and an interlayer insulation layer in the binding area of the display panel in FIG. 5.
FIG. 17 is a schematic diagram of a display device according to some embodiments of the present disclosure.

### EMBODIMENTS OF THE INVENTION

The technical solutions in the embodiments of the present disclosure will be clearly and completely described below with reference to the accompanying drawings in the embodiments of the present disclosure. It is apparent that the described embodiments are only some embodiments of the present disclosure, but not all embodiments thereof. Based on the embodiments in the present disclosure, all other embodiments obtained by those skilled in the art without making creative efforts fall within the scope of protection of the present disclosure.

In the description of the present disclosure, it needs to be understood that orientation or positional relationship indicated by the terms "center", "longitudinal", "transverse", "length", "width", "thickness", "upper", "lower", "front", "back", "left", "right", "vertical", "horizontal", "top", "bottom", "inside", "outside", "clockwise", "counterclockwise", etc., are based on the orientation or positional relationship shown in the drawings, which are only for the convenience of describing the present disclosure and simplifying the description, and does not indicate or imply that the device or element referred to must have a specific orientation, be constructed and operated in a specific orientation, Therefore, it cannot be construed as a limitation on this disclosure. In addition, the terms "first" and "second" are used for descriptive purposes only and cannot be understood as indicating or implying relative importance or implicitly indicating the quantity of indicated technical features. Thus, features defined as "first" and "second" may explicitly or implicitly include one or more of the described features. In the description of this disclosure, "plurality" means two or more, unless otherwise explicitly and specifically limited.

In the description of this disclosure, it should be noted that, unless otherwise clearly stated and limited, the terms "installation", "interconnection" and "connection" should be understood in a broad sense. For example, it may be a fixed connection, a detachable connection, or an integrated connection; may be a mechanical connection, an electrical connection, or communication with each other; may be a direct connection, an indirect connection through an intermediary, an internal connection between two elements, or an interaction between two elements. For those of ordinary skill in the art, the specific meanings of the above terms in the present disclosure can be understood according to specific circumstances.

In the present disclosure, unless otherwise expressly stated and limited, a first feature being "above" or "below" a second feature may include the first feature directing contacting the second feature, and the first feature contacting the second feature through an additional feature therebetween rather than being in direct contact. Furthermore, the first feature being "above", "over", or "on" the second feature may include the first feature being directly above and diagonally above the second feature, or simply mean that the first feature is higher in level than the second feature. The first feature being "under", "below", or "beneath" the second feature may include the first feature being directly below and diagonally below the second feature, or simply mean that the first feature is lower in level than the second feature.

The following disclosure provides many different embodiments or examples for implementing various structures of the present disclosure. To simplify the disclosure of the present application, the components and arrangements of specific examples are described below. Of course, they are merely examples and are not intended to limit the disclosure. Furthermore, the present disclosure may repeat reference numbers and/or reference letters in different examples, such repetition is for the purposes of simplicity and clarity and does not by itself indicate a relationship between the various embodiments and/or arrangements discussed. In addition, this disclosure provides examples of various specific processes and materials, but one of ordinary skill in the art will recognize the application of other processes and/or the use of other materials.

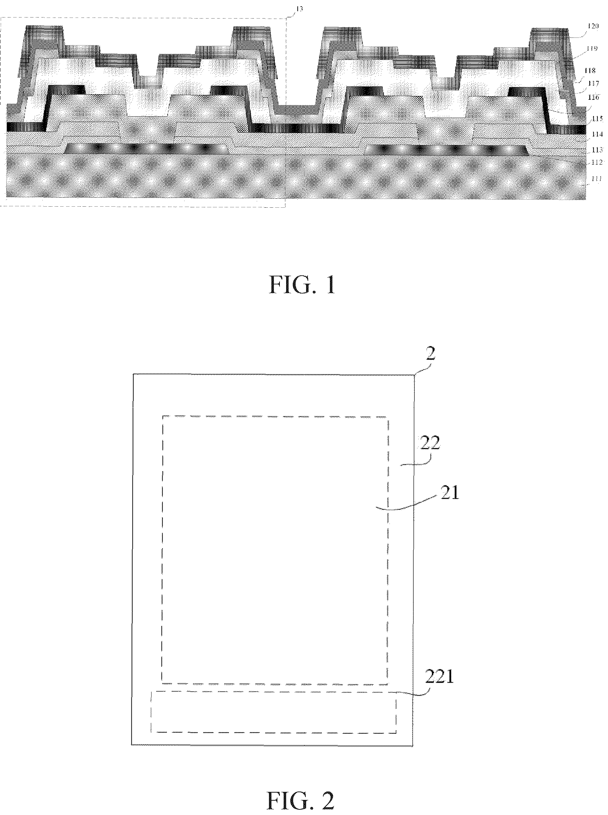

In order to achieve connection with a drive chip, an existing display device will be configured with binding terminals in a binding area. The binding terminals are formed through metal connections of film layers, and an insulation layer is set between the binding terminals to prevent signal crosstalk. As shown in FIG. 1, it can be seen that a display device includes a substrate 111, a barrier film (not shown), a buffer film (not shown), a first gate film 112, a first gate insulation film 113, and a first interlayer dielectric film 114, a first source and drain film 115, a second interlayer dielectric film 116, a second source and drain film 117, a first touch insulation film 118, a first touch metal film (not shown) , a second touch insulation film 119, and a second touch metal film 120, which are arranged in sequence. The metals in the first gate film 112, the first source and drain film 115, the second source and drain film 117, and the second touch metal film 120 are connected to form binding terminals 13, and the insulation layers are stacked between adjacent binding terminals 13, thereby avoiding a short circuit between the adjacent binding terminals.

When the display device is tested, it was found that disengagement occurred between an interlayer insulation layer and an insulation layer in a touch layer in the binding area of a display panel. Through mechanical analysis of the display device, it was found that this was due to a metal film (the second source and drain film 117 in FIG. 1) between the two interlayer dielectric films 116 and the first touch insulation film 118. In a high temperature environment, a thermal expansion coefficient of a metal is about an order of magnitude higher than a thermal expansion coefficient of an inorganic layer, therefore a large thermal stress is generated at a root of the metal film. Besides, a structural change at the root results in a large stress concentration. This leads to a structural failure when the thermal stress exceeds material strength or interface strength, such as the disengagement between the second interlayer dielectric film and the first touch insulation film, which causes abnormal display when the display device is lit. Therefore, the existing display device has a technical problem that the disengagement between the interlayer insulation layer and the insulation layer in the touch layer results in abnormal display of the display device.

In view of the above technical problems, embodiments of the present disclosure provide a display panel and a display device to address the above technical problems.

As shown in FIGS. 2 to 7, embodiments of the present disclosure provide a display panel. A display panel 2 includes a display area 21 and a binding area 221 located on at least one side of the display area 21. The binding area 221 includes terminal areas 321 and interval areas, and each interval area is located between two adjacent terminal areas 321. Each terminal area 321 is provided with a binding terminal 31. The display panel 2 includes a substrate 411, an interlayer insulation layer 41, a source and drain layer 42, and a touch layer 43. The interlayer insulation layer 41 is disposed on one side of the substrate 411, and includes an interlayer insulation portion 422a provided in the binding area 221. The source and drain layer 42 is disposed on a side of the interlayer insulation layer 41 away from the substrate, and includes a source and drain portion 423a provided in the binding area. The touch layer 43 is disposed on a side of the source and drain layer 42 away from the interlayer insulation layer 41, and includes an isolation layer 44. The isolation layer 44 includes an isolation portion 44a disposed in the binding area 221.

In the binding area 221, the source and drain portion 423a is disposed between the interlayer insulation portion 422a and the isolation portion 44a, the isolation portion 44a is in contact with the source and drain portion 423a and the interlayer insulation portion 422a, and at least one of the interlayer insulation portion 422a and the isolation portion 44a includes a groove 50 formed in an interval area 322.

Embodiments of the present disclosure provide a display panel in which at least one of the interlayer insulation portion and the isolation portion includes a groove formed in an interval area, so that the groove can release film stress of at least one of the interlayer insulation portion and the isolation portion, and interface stress between the interlayer insulation portion and the isolation portion is reduced, thereby avoiding disengagement between the interlayer insulation portion and the isolation portion. Further, even if the interlayer insulation portion and the isolation portion are disengaged, the groove may prevent the disengagement from spreading further, thereby improving a yield of the display panel.

Specifically, as shown in FIG. 2, the display panel 2 includes a display area 21 and a non-display area 22 including the binding area 221. In embodiments of the present disclosure, the non-display area is arranged around the display area 21, serving as an example for description. However, the embodiments of the present disclosure are not limited thereto. The non-display area may not be arranged around the display area, optionally, the non-display area may be arranged on a back of the display panel. Besides, a design of the binding area is not limited thereto. The binding area may be bent to the back of the display panel, and the binding area is not limited to being located on a lower side of the display area.

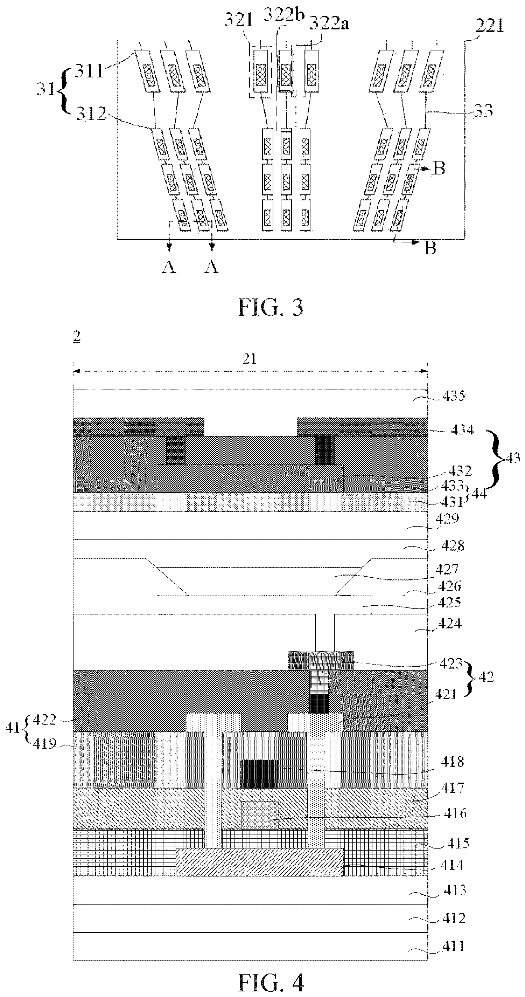

Specifically, as shown in FIG. 3, the binding terminals 31 may include input terminals 311 and output terminals 312. The input terminals 311 may each be connected to a trace (such as a data line or a scan line) in the display area, and the output terminals 312 may each be connected to a drive chip. The input terminals 311 are connected to the output terminals 312 through connection wires 33, and a column of input terminals 311 is connected to a corresponding column of output terminals 312 through a corresponding connecting wire 33. However, the embodiments of the present disclosure are not limited thereto. Other designs of connection to a drive chip through binding terminal(s), may adopt the designs in the present disclosure.

Specifically, FIG. 3 only shows one row of input terminals 311 and multiple rows of output terminals 312, but the embodiments of the present disclosure are not limited thereto. The numbers of the rows and the columns of the input terminals 311 and the numbers of the rows and the columns of the output terminals 312 may be set according to requirements.

Specifically, the interlayer insulation layer is formed using a high-temperature process, while the isolation layer is formed using a low-temperature process to prevent a high-temperature process from affecting performance of luminescent material. Due to the difference in the processes, even if the materials of the interlayer insulation layer and the isolation layer are same, there will still be a certain difference in the performance of the interlayer insulation layer and the isolation layer, resulting in low interface strength therebetween and accordingly resulting in easy disengagement therebetween when subjected to stress. In the embodiments of the present disclosure, at least one of the interlayer insulation layer and the isolation layer is provided with a groove to release stress, thus preventing disengagement between the interlayer insulation portion and the isolation portion. Further, even if the interlayer insulation portion and the isolation portion are disengaged, the groove may prevent the disengagement from spreading further, thereby improving a yield of the display panel.

Specifically, one of the current methods for alleviating the disengagement of film layers in a display device is to improve interface strength between the interlayer insulation layer and the isolation layer, for example, by using plasma surface treatment technology. However, experiments have shown that an interface strength enhancement effect brought by this method is limited. Besides, the additional processes will lead to a decrease in preparation efficiency and an increase in production costs. Another method is to change a material of the film layer(s), but since the interface strength of different film layers is different, a change in the strength of a film layer requires simultaneous verification of its mechanical properties, optical properties, and electrical properties, and verification of each item involves many aspects, for example, the mechanical properties involve in elastic modulus, film formation stress, film strength, and interface strength, and may take a long time and may not meet requirements on other aspects. The embodiments of the present disclosure have considered that during high temperature processes, a structural stress field predominantly exhibits local characteristics. Therefore, a local structural form has a greater impact on a state of local stress. Based on this characteristic, at least one of the interlayer insulation portion and the isolation portion is grooved to release stress and alleviate the disengagement between the interlayer insulation portion and the isolation portion.

In some embodiments, one of the interlayer insulation portion and the isolation portion may include a groove formed in an interval area, through which the stress is released and the disengagement is prevented from spreading, thereby improving the yield of the display panel.

In some embodiments, as shown in FIGS. 4 to 7, the isolation layer 44 includes a first touch insulation layer 431 and a second touch insulation layer 433. The first touch insulation layer 431 is disposed between the source and drain layer 42 and the second touch insulation layer 433. The isolation portion 44a includes a first touch insulation portion 431a in the first touch insulation layer 431 and a second touch insulation portion 433a in the second touch insulation layer 433. At least one of the interlayer insulation portion 422a, the first touch insulation portion 431a, and the second touch insulation portion 433a includes a groove 50 formed in the interval area 322. By configuring at least one of the interlayer insulation portion, the first touch insulation portion, and the second touch insulation portion to include a groove formed in the interval area, the groove may release film stress of at least one of the interlayer insulation portion, the first touch insulation portion, and the second touch insulation portion, thereby avoiding the disengagement between the interlayer insulation portion and the first touch insulation portion. Further, even if the interlayer insulation portion and the first touch insulation portion are disengaged, the groove may prevent the disengagement from spreading further, thereby improving a yield of the display panel.

In some embodiments, one of the interlayer insulation portion, the first touch insulation portion, and the second touch insulation portion may include a groove formed in the interval area, through which the stress is released and the disengagement is prevented from spreading, improving the yield of the display panel.

Specifically, the interlayer insulation portion may include a groove formed in the interval area. Considering that the stress is mainly generated on the interlayer insulation portion and the first touch insulation portion, by forming the groove on the interlayer insulation portion, the stress may be released through the interlayer insulation portion. Furthermore, when the disengagement occurs between the interlayer insulation portion and the first touch insulation portion, the groove may prevent the disengagement from further spreading, thereby improving the yield of the display panel.

Specifically, the first touch insulation portion may include a groove formed in the interval area. Considering that stress is mainly generated on the interlayer insulation portion and the first touch insulation portion, by forming the groove on the first touch insulation portion, the stress may be released through the first touch insulation portion. Furthermore, when the disengagement occurs between the interlayer insulation portion and the first touch insulation portion, the groove may prevent the disengagement from further spreading, thereby improving the yield of the display panel.

Specifically, the second touch insulation portion may include a groove formed in the interval area. By forming the groove in the second touch insulation portion, the stress may be released through the second touch insulation portion. Furthermore, when the disengagement occurs between the interlayer insulation portion and the first touch insulation portion, the groove may prevent the disengagement from further spreading, thereby improving the yield of the display panel.

Specifically, when a groove is formed on one of the interlayer insulation portion, the first touch insulation portion, and the second touch insulation portion, other film layers located on each of these film layers may cover the groove. For example, the first touch insulation portion is provided on the interlayer insulation portion, and when the interlayer insulation portion is grooved, the first touch insulation portion may fill the groove. When the second touch insulation portion is grooved, if there are other insulation film layers on the second touch insulation portion, the groove of the second touch insulation portion may be filled by the other insulation film layers; if there are no other insulation film layers on the second touch insulation portion, a process may be performed to fill the groove of the second touch insulation portion.

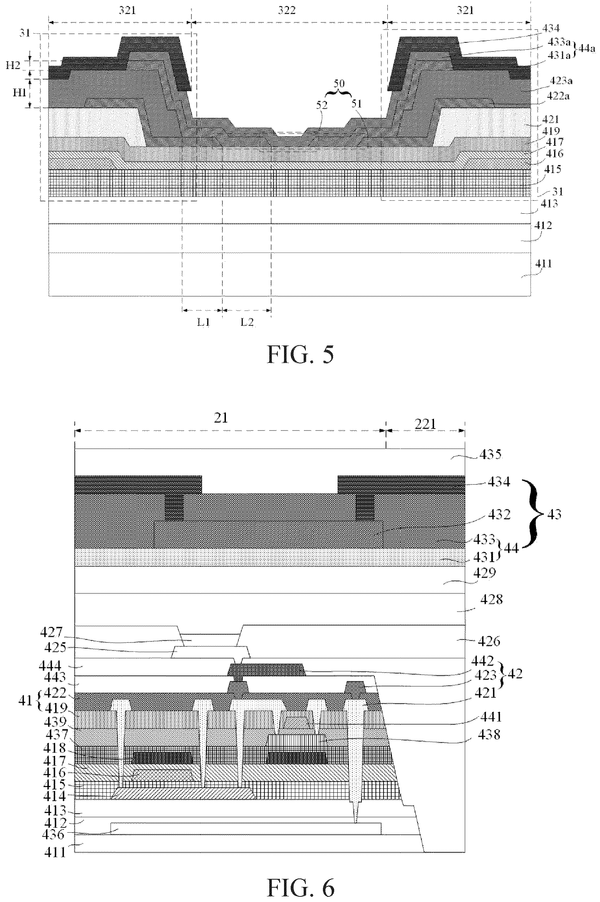

In some embodiments, as shown in FIGS. 4 and 5, the interlayer insulation layer 41 includes a first groove 51 formed in the interval area 322. By configuring the interlayer insulation layer to include the first groove formed in the interval area, the interlayer insulation portion may release stress, and even if the interlayer insulation portion and the first touch insulation portion are disengaged, the groove may prevent the disengagement from spreading further, thereby improving a yield of the display panel.

In some embodiments, as shown in FIGS. 4 and 5, the first touch insulation portion 431a includes a second groove 52 formed in the interval area 322. There is a gap between an edge of the first groove 51 and an edge of the source and drain portion 423a. There is a gap between an edge of the second groove 52 and the edge of the source and drain portion 423a. By configuring the first touch insulation layer to include the second groove formed in the interval area, both the interlayer insulation portion and the first touch insulation portion may release stress, and even if the interlayer insulation portion and the first touch insulation portion are disengaged, the grooves may prevent the disengagement from spreading further, thereby improving a yield of the display panel. Moreover, the gap between the edge of the first groove and the edge of the source and drain portion and the gap between the edge of the second groove and the edge of the source and drain portion may prevent water and oxygen from entering into a metal layer and changing impedance or other properties of the metal layer, thereby further improving the yield of the display panel.

Specifically, it can be understood that the groove 50 includes the first groove 51 and the second groove 52.

In some embodiments, as shown in FIG. 5, the first touch insulation portion 431a is disposed in the first groove 51, and a projection of the second groove 52 on the substrate 411 is within a projection of the first groove 51 on the substrate 411. By disposing the first touch insulation portion in the first groove and configuring the projection of the second groove on the substrate to be within the projection range of the first groove on the substrate, a width of the second groove is smaller than a width of the first groove, which allows the first touch insulation portion to fill the first groove. In this way, when water and oxygen come from the second groove and the first groove, the first touch insulation portion and the interlayer insulation portion may block the water and oxygen and prolong an infiltration path of the water and oxygen, avoiding the water and oxygen infiltration from causing display panel failure, and improving the yield of the display panel.

In some embodiments, as shown in FIG. 5, the second touch insulation portion 433a has no groove in the interval area 322, and the second touch insulation portion 433a fills the second groove 52. By having the second touch insulation portion without a groove in the interval area and filling the second touch insulation portion into the second groove, water and oxygen may be prevented from directly infiltrating through the second groove, and even if water and oxygen enter through the second groove, due to the second touch insulation portion filling the second groove, the infiltration path of the water and oxygen may be prolonged, avoiding performance deterioration of the display panel caused by water and oxygen infiltration and improving the yield of the display panel.

Specifically, the first groove may extend through the interlayer insulation portion, and the second groove may extend through the first touch insulation portion, so that when the second touch insulation portion fills the second groove, the first touch insulation portion is actually filled with the second touch insulation portion, so that no matter where water and oxygen infiltrate, the effect of prolonging the infiltration path of the water and oxygen may be achieved.

In some embodiments, as shown in FIG. 5, a spacing range L1 between the edge of the first groove 51 and the edge of the source and drain portion 423a is one to three times greater than a thickness H1 of the source and drain portion 423a. By configuring the spacing range between the edge of the first groove and the edge of the source and drain portion to be one to three times greater than the thickness of the source and drain portion, there is a certain distance between the edge of the first groove and the edge of the source and drain portion, thus even if water and oxygen infiltration occurs, the certain distance may increase the infiltration path of the water and oxygen and improve the yield of the display panel.

Specifically, when the source and drain portion between the interlayer insulation portion and the first touch insulation portion only includes portion of one source and drain layer, the spacing between the first groove and the source and drain portion may be 1 to 1.5 times of the thickness of the source and drain portion, or 1 to 3 times of the thickness of the source and drain portion. When the source and drain portion between the interlayer insulation portion and the first touch insulation portion include portion of two source and drain layers, the spacing between the first groove and the source and drain portions may be 1 to 1.5 times of the thickness of the source and drain portions.

In some embodiments, as shown in FIG. 5, a spacing range L2 between the edge of the second groove 52 and the edge of the first groove 51 is one to three times greater than a thickness H2 of the first touch insulation portion 431a. By configuring the spacing range between the edge of the second groove and the edge of the first groove to be one to three times greater than a thickness of the first touch insulation portion, there is a certain distance between the edge of the first groove and the edge of the second groove, thus even if water and oxygen infiltration occur, it may increase the infiltration path of the water and oxygen and improve the yield of the display panel.

Specifically, the above-mentioned embodiments are described by taking an example where the interlayer insulation portion includes the first groove formed in the interval area, and the first touch insulation portion includes the second groove formed in the interval area. However, the embodiments of the present disclosure are not limited thereto. It is possible that the interlayer insulation portion may include a first groove formed in the interval area, the second touch insulation portion may include a third groove formed in the interval area, the first touch insulation portion may not be provided with any groove, and the first touch insulation portion may fill the first groove. It is also possible that the interlayer insulation portion has no groove, the first touch insulation portion includes a second groove formed in the interval area, and the second touch insulation layer includes a third groove formed in the interval area.

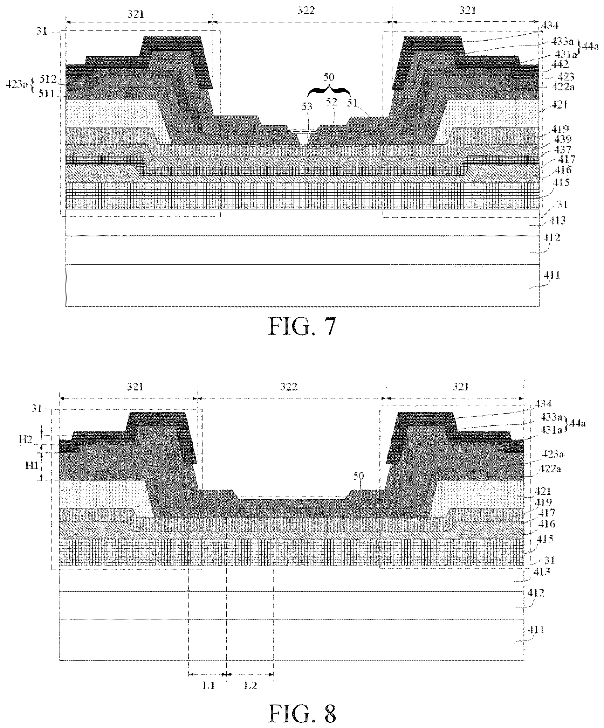

In some embodiments, as shown in FIG. 7, the second touch insulation portion 433a is provided with a third groove 53 in the interval area 322, and the second touch insulation portion 433a is disposed in the second groove 52, a projection of the third groove 53 on the substrate 411 is within a projection of the second groove 52 on the substrate 411. By forming the third groove in the interval area of the second touch insulation layer, the stress may be further released through the third groove in the second touch insulation portion, and when disengagement occurs between the interlayer insulation portion and the first touch insulation portion, the first groove, the second groove, and the third groove may further prevent the disengagement from further spreading, thereby improving the yield of the display panel. Moreover, by disposing the second touch insulation portion in the second groove and arranging the projection of the third groove to be within the projection of the second groove on the substrate, it is possible to avoid water and oxygen from infiltrating into a metal layer and changing impedance or other properties of the metal layer, thereby further improving the yield of the display panel.

Specifically, as shown in FIG. 7, the groove 50 includes the first groove 51, the second groove 52, and the third groove 53.

In some embodiments, as shown in FIG. 8, the first touch insulation portion 431a includes a groove 50 in the interval area 322, and the interlayer insulation portion 422a has no groove in the interval area 322. By arranging the first touch insulation portion to include the groove in the interval area, and the interlayer insulation portion to include no groove in the interval area, the stress may be released through the groove in the first touch insulation portion, and when the interlayer insulation portion is disengaged from the first touch insulation portion, the groove may further prevent the disengagement from further spreading, thereby improving the yield of the display panel.

Specifically, when the first touch insulation portion is provided with a groove, the second touch insulation portion may be provided with a groove, or may not be provided with any groove.

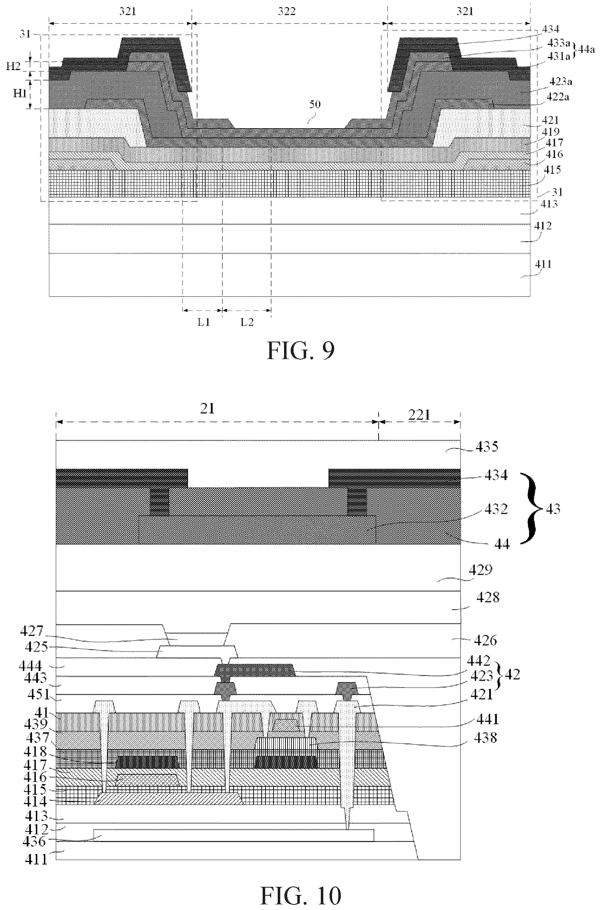

In some embodiments, as shown in FIG. 9, the second touch insulation portion 433a includes a groove 50 formed in the interval area 322, and neither of the interlayer insulation portion 422a and the first touch insulation portion 431a has any groove in the interval area 322. By configuring the second touch insulation portion to include the groove in the interval area, and configuring the interlayer insulation portion and the first touch insulation portion not to include any groove in the interval area, the stress may be released through the groove in the second touch insulation portion, and when the interlayer insulation portion is disengaged from the first touch insulation portion, the groove may further prevent the disengagement from further spreading, thereby improving the yield of the display panel.

In some embodiments, as shown in FIGS. 10 to 12, the isolation layer 44 includes one touch insulation layer, and the touch insulation layer includes a groove 50 in the interval area 322. By configuring the isolation layer to only include one layer of touch insulation layer and forming a groove in the touch insulation layer, the groove in the touch insulation portion may release stress, and when the interlayer insulation portion is disengaged from the insulation portion, the groove may further prevent the disengagement from further spreading, thereby improving the yield of the display panel.

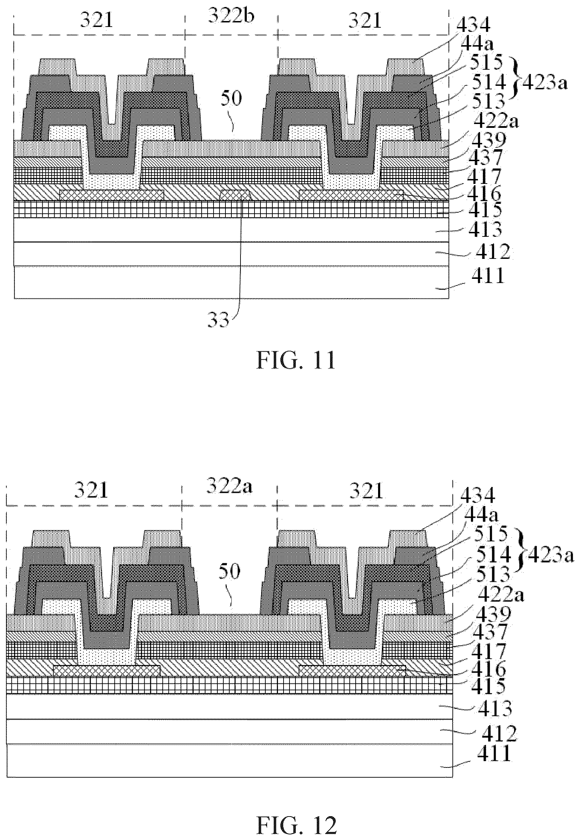

Specifically, as shown in FIG. 11, FIG. 11 shows that the isolation portion 44a is provided with a groove in a second interval area 322b. FIG. 12 shows that the isolation portion 44a is provided with a groove in the first interval area 322a. It can be understood that the isolation portion 44a may be provided with a groove in either the first interval area 322a or the second interval area 322b, or may be provided with grooves in both the first interval area 322a and the second interval area 322b.

In some embodiments, as shown in FIG. 5, the interlayer insulation layer 41 includes a first interlayer insulation layer 419 and a second interlayer insulation layer 422, and the source and drain layer 42 includes a first source and drain layer 421 and a second source and drain layer 423, the first interlayer insulation layer 419 is disposed between the first source and drain layer 421 and the substrate 411, the second interlayer insulation layer 422 is disposed between the first source and drain layer 421 and the second source and drain layer 423, and the interlayer insulation portion 422a is formed in the second interlayer insulation layer 422. When the interlayer insulation layer includes the first interlayer insulation layer and the second interlayer insulation layer, and the source and drain layer includes the first source and drain layer and the second source and drain layer, the second interlayer insulation layer will be in contact with the first touch insulation layer, so the second interlayer insulation layer may be arranged to include the interlayer insulation portion, and at least one of the interlayer insulation portion, the first touch insulation layer, and the second touch insulation layer may be arranged to have a groove, which may prevent disengagement between the interlayer insulation portion and the first touch insulation portion, and even if disengagement occurs between the interlayer insulation portion and the first touch insulation portion, it may prevent the disengagement from spreading, improving the yield of the display panel.

Specifically, the second source and drain layer 423 may include the source and drain portion 423a.

Specifically, the above embodiments are described with the example where the interlayer insulation layer includes the first interlayer insulation layer and the second interlayer insulation layer, and the source and drain layer includes the first source and drain layer and the second source and drain layer. However, the embodiments of the present disclosure are not limited thereto. The interlayer insulation layer may have only one layer, and there may be only one source and drain layer. **In** this case, the interlayer insulation layer includes the interlayer insulation portion, and the source and drain layer includes the source and drain portion.

Specifically, the above embodiments are described with the example where the interlayer insulation layer includes the first interlayer insulation layer and the second interlayer insulation layer, the source and drain layers include the first source and drain layer and the second source and drain layer, and the second interlayer insulation layer includes the interlayer insulation portion. This is because during a manufacturing process, a source and drain layer closest to the touch layer will be used as a film layer to form the binding terminals to facilitate connection to the drive chip. Therefore, the second interlayer insulation layer, which is closest to the touch layer, will be in contact with the first touch insulation layer. However, it can be understood that the binding terminals may include portions of the first source and drain layer but not include any portion of the second source and drain layer. In this case, the binding area is only provided with portions of the first interlayer insulation layer, but not provided with any portion of the second interlayer insulation layer, then the first interlayer insulation layer may include the interlayer insulation portion. That is, when the interlayer insulation layer and the source and drain layer include multiple layers, the film layers of the interlayer insulation portion and the source and drain portion may be determined according to the film layer used for the binding terminals, and it is not limited that a interlayer insulation layer and a source and drain layer, which are closest to the touch layer, respectively include the interlayer insulation portion and the source and drain portion.

In some embodiments, as shown in FIGS. 6 and 7, the source and drain layer 42 further includes a third source and drain layer 442, and the third source and drain layer 442 is disposed on a side of the second source and drain layer 423 away from the second interlayer insulation layer 422, and the source and drain portion 423a is disposed in at least one of the second source and drain layer 423 and the third source and drain layer 442. When the source and drain layer includes the third source and drain layer, at least one of the second source and drain layer and the third source and drain layer will be used to form a portion of the (each) binding terminal. Then, correspondingly the at least one of the second source and drain layer and the third source and drain layers includes a source and drain portion. At least one of the interlayer insulation portion, the first touch insulation portion, and the second touch insulation portion includes a groove in the interval area, thereby preventing disengagement between the interlayer insulation portion and the first touch insulation portion, and even if the disengagement occurs between the interlayer insulation portion and the first touch insulation portion, it may prevent the disengagement from spreading, improving the yield of the display panel.

In some embodiments, as shown in FIG. 7, the source and drain portion includes a first portion 511 formed in the second source and drain layer 423, and the source and drain portion includes a second portion 512 formed in the third source and drain layer 423. The first portion 511 of the source and drain portion and the second portion 512 of the source and drain portion are connected. The first portion 511 of the source and drain portion is disposed between the second portion 512 of the source and drain portion and the interlayer insulation portion 422a. The first portion 511 of the source and drain portion is in contact with the interlayer insulation portion 422a, and the second portion 512 of the source and drain portion is in contact with the first touch insulation portion 431a. By configuring the second source and drain layer to include the first portion of the source and drain portion and configuring the third source and drain layer to include the second portion of the source and drain portion, the binding terminals may be formed by multiple layers of source and drain layers, reducing impedance of the binding terminals. Furthermore, at least one of the interlayer insulation portion, the first touch insulation portion, and the second touch insulation portion includes a groove formed in the interval area, thereby preventing disengagement occurs between the interlayer insulation portion and the first touch insulation portion. Even if the disengagement occurs between the interlayer insulation portion and the first touch insulation portion, the groove may prevent the disengagement from spreading, improving the yield of the display panel.

In some embodiments, as shown in FIGS. 10 to 12, the source and drain layer 42 includes a first source and drain layer 421, a second source and drain layer 423, and a third source and drain layer 442. The drain portion 423a is formed in at least one of the first source and drain layer 421, the second source and drain layer 423, and the third source and drain layer 442. By disposing the source and drain portion in at least one of the first source and drain layer, the second source and drain layer, and the third source and drain layer, the source and drain portion may be disposed as required.

Specifically, the source and drain portion may be disposed in one of the first source and drain layer, the second source and drain layer, and the third source and drain layer, to reduce a thickness of the binding terminals and avoid the binding terminals from protruding excessively. Alternatively, the source and drain portion may be formed in two or three layers of the first source and drain layer, the second source and drain layer, and the third source and drain layer, to reduce the impedance of the binding terminals.

In some embodiments, as shown in FIGS. 10 and 11, the source and drain portion 423a includes a third portion 513 disposed in the first source and drain layer 421, a fourth portion 514 disposed in the second source and drain layer 423, and a fifth portion 515 disposed in the third source and drain layer 442. The fourth portion 514 connects the third portion 513 and the fifth portion 515, the third portion 513 is in contact with the interlayer insulation portion 422a, and the fifth portion 515 is in contact with the isolation portion 44a. By configuring the source and drain portion to include the third portion disposed in the first source and drain layer, the fourth portion disposed in the second source and drain layer, and the fifth portion disposed in the third source and drain layer, the impedance of the binding terminals is relatively low, which improves the electrical properties of the binding terminals.

In some embodiments, as shown in FIGS. 3, 13, and 14, the interval area 322 includes first interval areas 322a disposed along a first direction X and second interval areas 322b disposed along a second direction Y, the (each) groove 50 is formed in at least one of the first interval areas 322a and the second interval areas 322b, and an angle between the first direction X and the second direction Y is greater than 0 and less than or equal to 90 degrees. By arranging the groove in at least one of the first interval areas and the second interval areas, the stress in at least one direction may be released through the groove(s), and when the disengagement occurs between the interlayer insulation portion and the isolation portion, the groove may further prevent the disengagement from spreading, thereby improving the yield of the display panel.

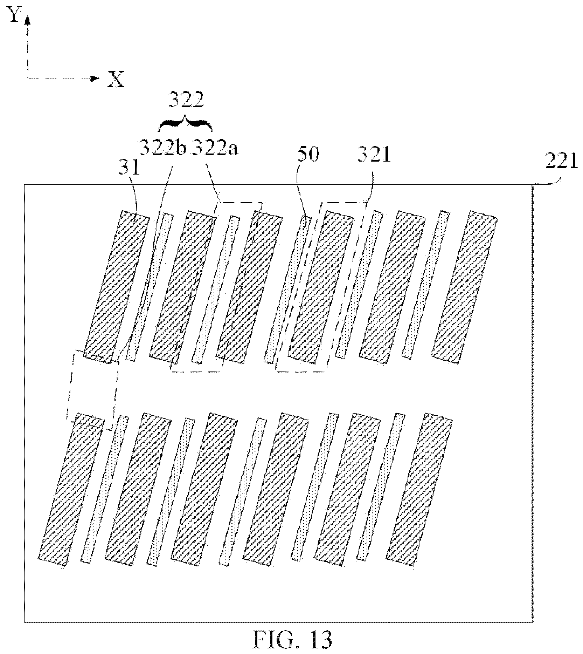

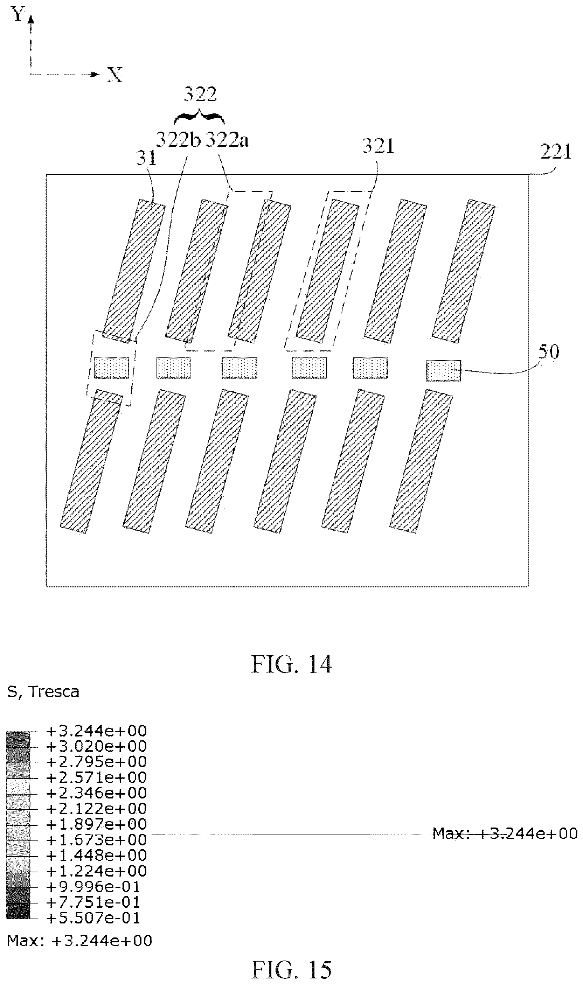

Specifically, FIG. 3 shows that only a portion of the first interval areas 322a and a portion of the second interval areas 322b are provided with grooves. FIG. 13 shows that the first interval areas 322a are provided with an array of grooves. FIG. 14 shows that the second interval areas 322b are provided with an array of grooves. It can be understood that the embodiments of the present disclosure are not to limit the area in which the grooves are provided. The grooves may be formed in one area or in multiple areas in the interval areas. In FIGS. 13 and 14, the grooves are arranged separately, but the embodiments of the present disclosure are not limited thereto. The grooves in one row or one column may be connected, or the grooves formed in the first interval area and the grooves formed in the second interval area may be connected.

Specifically, as shown in FIGS. 5 and 7, the binding terminals 31 may each include a portion of a first gate layer 416 located in the binding area 221, a portion of the first source and drain layer 421 located in the binding area 221, the source and drain portion 423a, and a portion of a second touch metal layer 434 located in the binding area 221. However, the embodiments of the present disclosure are not limited thereto. According to different requirements (for example, requirements for lower impedance or for smaller thickness) for the binding terminals, a design of the binding terminals may be different. For example, the display panel may include the first source and drain layer, the second source and drain layer, and the third source and drain layer, but the binding terminals may each only include a portion of the first gate layer located in the binding area, a portion of the first source and drain layer located in the binding area, and a portion of the second touch metal layer located in the binding area. Optionally, the binding terminals may each include a portion of the first gate layer located in the binding area, a portion of the first source and drain layer located in the binding area, and the source and drain portion formed by the second source and drain layer or the third source and drain layer. Optionally, the binding terminals may each include a portion of the first gate layer located in the binding area, a portion of the first source and drain layer located in the binding area, and the source and drain portion formed by the second source and drain layer and the third source and drain layer, which will not be further described herein.

Specifically, as shown in FIG. 4, the display panel 2 further includes a barrier layer 412, a buffer layer 413, a first active layer 414, a first gate insulation layer 415, a first gate layer 416, a second gate insulation layer 417, a second gate layer 418, a planarization layer 424, a pixel electrode layer 425, a pixel definition layer 426, a luminescent material layer 427, a common electrode layer 428, an encapsulation layer 429, and a cover plate 435.

Specifically, a material of the first active layer may be low-temperature polysilicon.

Specifically, as shown in FIG. 4, the touch layer 43 includes a first touch metal layer 432 and the second touch metal layer 434. FIG. 4 illustrates the example where the first touch metal layer 432 forms a bridge, and the second touch metal layer 434 forms touch electrodes, but the embodiments of the present disclosure are not limited thereto, and the positions of the two may be exchanged.

Specifically, as shown in FIG. 6, the display panel 2 further includes a light-shielding layer 436, a third gate insulation layer 437, a second active layer 438, a fourth gate insulation layer 439, a third gate layer 441, a first planarization layer 443, and a second planarization layer 444, which are arranged in sequence.

Specifically, as shown in FIG. 10, the display panel 2 further includes a third planarization layer 451.

Specifically, a material of the second active layer may be metal oxide.

Specifically, it can be understood that the binding terminals will be formed by using different film layers of the display panel according to different needs. Therefore, when the film layer structures of display areas of display panels are the same, the binding terminals in the binding areas may be different. For example, when the display area of the display panel is provided with the first source and drain layer, the second source and drain layer, and the third source and drain layer, a binding terminal may only use metal in the first source and drain layer, while another binding terminal may only use metals in the first source and drain layer and the second source and drain layer. When the film layer structures of the display areas of the display panels are different, the structures of the binding terminals in the binding area may be the same. For example, the display area of a display panel is provided with the first source and drain layer, the second source and drain layer, and the third source and drain layer, and the display area of another display panel is only provided with the first source and drain layer and the second source and drain layer, but the binding terminals of the two display panels only use metals in the first source and drain layer and the second source and drain layer. That is, the structures of the binding areas may be as shown in FIG. 5. Similarly, regarding other structures of the binding area, there may be multiple structures of the display area, and the film layers where the binding terminals are located may be determined based on the structures of the binding area. The film layer structure of the display area is not limited herein, and the display panel may include one source and drain layer or multiple source and drain layers, one gate layer or multiple gate layers, and one active layer or multiple active layers, all of which are suitable for the design in the present disclosure, and will not be described here.

Specifically, the above embodiments specifically describe the structure of a portion of the display panel. It can be understood that the embodiments of the present disclosure are not to limit the specific film layer structure of the display panel, as long as the normally operable binding terminals may be formed on the display panel. The number and location of insulation layers (including an interlayer insulation layer and an isolation layer) and the number and location of metal layers (including a source and drain layer, a gate layer, and a touch metal layer) are not limited, and the corresponding display panels are all suitable for the design of the display panel provided in the embodiments of the present disclosure.

Specifically, it can be understood that the above embodiments describe the display panel in terms of each film layer and each structure, and if there is no conflict between the embodiments, the embodiments may be combined. For example, the spacing range between the edge of the first groove and the edge of the source and drain portion ranges from one to three times the thickness of the source and drain portion, and the spacing range between the edge of the second groove and the edge of the first groove ranges from one to three times the thickness of the first touch insulation portion.

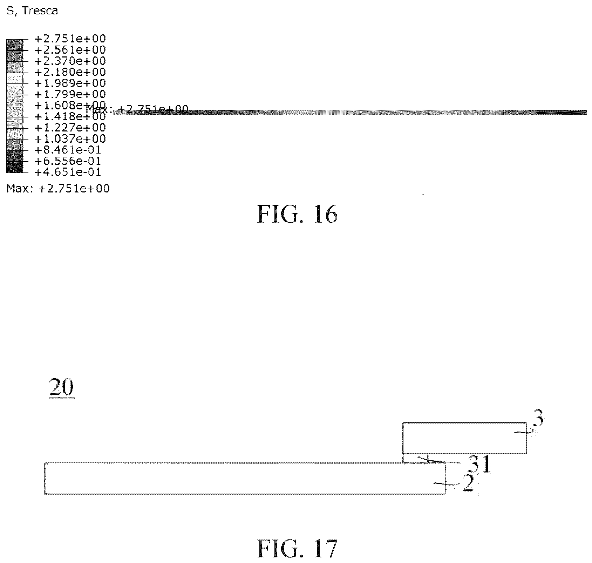

Taking the display device shown in FIG. 1 and the display panel shown in FIG. 5 as examples, the interface stress between the first touch insulation layer and the interlayer insulation layer in the binding area is tested under reliability test conditions, respectively. The interface stress cloud diagrams shown in FIG. 15 and FIG. 16 are obtained. *"S, Tresca"* in FIG. 15 represents the interface stress, *"max"* represents the maximum interface stress. From the comparison of FIG. 15 and FIG. 16, it can be seen that the maximum interface stress between the first touch insulation layer and the interlayer insulation layer in the binding area of the display device shown in FIG. 1 is +3.244e+00 (i.e., 3.244) and the maximum interface stress between the first touch insulation layer and the interlayer insulation layer in the binding area of the display device shown in FIG. 5 is +2.751e+00 (i.e., 2.751). It can be seen that, compared to the existing technology, the interface stress between the first touch insulation layer and the interlayer insulation layer in the binding area of the display panel provided by the present disclosure is reduced by about 15%, which reduces the possibility of display panel failure and improves the yield rate of the display panel.

Additionally, embodiments of the present disclosure provide a display device, which includes the display panel as described in any of the above embodiments.

Specifically, as shown in FIG. 17, the display device 20 includes a display panel 2 and a driving chip 3. The driving chip 3 is connected to the binding terminal 31 in the display panel 2.

In the above embodiments, each embodiment is described with its own emphasis. For portions that are not described in detail in a certain embodiment, please refer to the relevant descriptions of other embodiments.

The above is a detailed introduction to a display panel and a display device provided by the embodiments of the present disclosure. Specific examples are used in this disclosure to illustrate the principles and implementation methods of the present disclosure. The description of the above embodiments is only used to help understand technical solutions and the core ideas of the present disclosure. Those of ordinary skill in the art should understand it is still possible to modify the technical solutions recorded in the foregoing embodiments, or to equivalently replace some of the technical features therein. However, these modifications or substitutions do not cause the essence of the corresponding technical solutions to depart from the scope of the technical solutions of the embodiments of the present disclosure.

## Claims

1. A display panel, **characterized in that** the display panel comprises a display area and a binding area located on at least one side of the display area,
the binding area comprises a plurality of terminal areas and a plurality of interval areas, each interval area is located between two adjacent ones of the plurality of terminal areas, and each terminal area is provided with a binding terminal, and
the display panel comprises:
a substrate;
an interlayer insulation layer disposed on one side of the substrate, wherein the interlayer insulation layer comprises an interlayer insulation portion provided in the binding area;
a source and drain layer disposed on a side of the interlayer insulation layer away from the substrate, wherein the source and drain layer comprises a source and drain portion provided in the binding area;
a touch layer disposed on a side of the source and drain layer away from the interlayer insulation layer, wherein the touch layer comprises an isolation layer, and the isolation layer comprises an isolation portion provided in the binding area;
wherein in the binding area, the source and drain portion is disposed between the interlayer insulation portion and the isolation portion, the isolation portion is in contact with the source and drain portion and the interlayer insulation portion, and at least one of the interlayer insulation portion and the isolation portion comprises one or more grooves each formed in a corresponding interval area of the plurality of interval areas.

2. The display panel of claim 1, wherein the isolation layer comprises a first touch insulation layer and a second touch insulation layer,
the first touch insulation layer is disposed between the source and drain layer and the second touch insulation layer,
the isolation portion comprises a first touch insulation portion in the first touch insulation layer and a second touch insulation portion in the second touch insulation layer, and
at least one of the interlayer insulation portion, the first touch insulation portion, and the second touch insulation portion comprises the one or more grooves formed in the interval areas.

3. The display panel of claim 2, wherein the interlayer insulation portion comprises a first groove formed in the interval areas.

4. The display panel of claim 3, wherein the first touch insulation portion comprises a second groove formed in the interval areas, there is a gap between an edge of the first groove and an edge of the source and drain portion, and there is a gap between an edge of the second groove and the edge of the source and drain portion.

5. The display panel of claim 4, wherein the first touch insulation portion is disposed in the first groove, and a projection of the second groove on the substrate is within a projection of the first groove on the substrate.

6. The display panel of claim 5, wherein the second touch insulation portion is not provided with any of the one or more groove formed in the interval areas, and the second touch insulation portion fills the second groove.

7. The display panel of claim 4, wherein a spacing range between the edge of the first groove and the edge of the source and drain portion is one to three times greater than a thickness of the source and drain portion.

8. The display panel of claim 4, wherein a spacing range between the edge of the second groove and the edge of the first groove is one to three times greater than a thickness of the first touch insulation portion.

9. The display panel of claim 4, wherein the second touch insulation portion is provided with a third groove in the interval areas, and the second touch insulation portion is disposed in the second groove, and a projection of the third groove on the substrate is within a projection of the second groove on the substrate.

10. The display panel of claim 2, wherein the first touch insulation portion comprises the one or more grooves formed in the interval areas, and the interlayer insulation portion is not provided with any of the one or more grooves formed in the interval areas.

11. The display panel of claim 2, wherein the second touch insulation portion comprises the one or more grooves formed in the interval areas, the interlayer insulation portion is not provided with any of the one or more grooves formed in the interval areas, and the first touch insulation portion is not provided with any of the one or more grooves formed in the interval areas.

12. The display panel of claim 1, wherein the isolation layer comprises one touch insulation layer, and the touch insulation layer comprises the one or more grooves formed in the interval areas.

13. The display panel of claim 1, wherein the interlayer insulation layer comprises a first interlayer insulation layer and a second interlayer insulation layer,
the source and drain layer comprises a first source and drain layer and a second source and drain layer,
the first interlayer insulation layer is disposed between the first source and drain layer and the substrate,
the second interlayer insulation layer is disposed between the first source and drain layer and the second source and drain layer, and
the interlayer insulation portion is formed in the second interlayer insulation layer.

14. The display panel of claim 13, wherein the source and drain layer further comprises a third source and drain layer,
the third source and drain layer is disposed on a side of the second source and drain layer away from the second interlayer insulation layer, and
the source and drain portion is disposed in at least one of the second source and drain layer and the third source and drain layer.

15. The display panel of claim 14, wherein the source and drain portion comprises a first portion formed in the second source and drain layer and a second portion formed in the third source and drain layer,
the first portion of the source and drain portion and the second portion of the source and drain portion are connected,
the first portion of the source and drain portion is disposed between the second portion of the source and drain portion and the interlayer insulation portion, and is in contact with the interlayer insulation portion, and
the second portion of the source and drain portion is in contact with the isolation portion.

16. The display panel of claim 1, wherein the source and drain layer comprises a first source and drain layer, a second source and drain layer, and a third source and drain layer,
the drain portion is formed in at least one of the first source and drain layer, the second source and drain layer, and the third source and drain layer.

17. The display panel of claim 16, wherein the source and drain portion comprises a third portion disposed in the first source and drain layer, a fourth portion disposed in the second source and drain layer, and a fifth portion disposed in the third source and drain layer,
the fourth portion connects the third portion and the fifth portion, the third portion is in contact with the interlayer insulation portion, and the fifth portion is in contact with the isolation portion.

18. The display panel of claim 1, wherein the plurality of interval areas comprise first interval areas disposed along a first direction and second interval areas disposed along a second direction,
each groove is formed in at least one of the first interval areas or in at least one of the second interval areas, and
an angle between the first direction and the second direction is greater than 0 and less than or equal to 90 degrees.

19. A display device, **characterized by** comprising a display panel and a drive chip, wherein the display panel comprises a display area and a binding area located on at least one side of the display area,
the binding area comprises a plurality of terminal areas and a plurality of interval areas, each interval area is located between two adjacent ones of the plurality of terminal areas, and each terminal area is provided with a binding terminal, the drive chip is connected to the binding terminal in the display panel, and
the display panel comprises:
a substrate;
an interlayer insulation layer disposed on one side of the substrate, wherein the interlayer insulation layer comprises an interlayer insulation portion provided in the binding area;
a source and drain layer disposed on a side of the interlayer insulation layer away from the substrate, wherein the source and drain layer comprises a source and drain portion provided in the binding area;
a touch layer disposed on a side of the source and drain layer away from the interlayer insulation layer, wherein the touch layer comprises an isolation layer, and the isolation layer comprises an isolation portion provided in the binding area;
wherein in the binding area, the source and drain portion is disposed between the interlayer insulation portion and the isolation portion, the isolation portion is in contact with the source and drain portion and the interlayer insulation portion, and at least one of the interlayer insulation portion and the isolation portion comprises one or more grooves each formed in a corresponding interval area of the plurality of interval areas.

20. The display device of claim 19, wherein the isolation layer comprises a first touch insulation layer and a second touch insulation layer,
the first touch insulation layer is disposed between the source and drain layer and the second touch insulation layer,
the isolation portion comprises a first touch insulation portion in the first touch insulation layer and a second touch insulation portion in the second touch insulation layer, and
at least one of the interlayer insulation portion, the first touch insulation portion, and the second touch insulation portion comprises the one or more grooves formed in the interval areas.
